Europäisches Patentamt

European Patent Office

Office européen des brevets

(11) Publication number: **0 291 602 B1**

(12) **EUROPEAN PATENT SPECIFICATION**

(45) Date of publication of patent specification: **30.12.92** (51) Int. Cl.5: **H01F 15/10**

(21) Application number: **87308516.1**

(22) Date of filing: **25.09.87**

(54) **Contact elements for miniature inductor.**

(30) Priority: **21.05.87 US 52070**

(43) Date of publication of application:
**23.11.88 Bulletin 88/47**

(45) Publication of the grant of the patent:
**30.12.92 Bulletin 92/53**

(84) Designated Contracting States:
**DE FR GB NL**

(56) References cited:
**EP-A- 0 175 461**

**PATENT ABSTRACTS OF JAPAN, vol. 7, no. 236 (E-205)[1381], 20th October 1983; & JP-A-58 124 213**

(73) Proprietor: **STANDEX INTERNATIONAL CORPORATION**
**Manor Parkway**
**Salem New Hampshire 03079(US)**

(72) Inventor: **Chamberlin, Edward R.**
**6523 Arborcrest Drive**
**Loveland Ohio(US)**

(74) Representative: **Allen, Oliver John Richard et al**
**Lloyd Wise, Tregear & Co. Norman House 105-109 Strand**
**London, WC2R 0AE(GB)**

Rank Xerox (UK) Business Services

## Description

This invention relates to miniature inductors and particularly to the securing of contact elements on the inductor so that the inductor can be surface mounted to a printed circuit board.

The inductor consists of a ferromagnetic core, a winding around the core, and contact elements to which the ends of the winding are soldered. The inductor is surface mounted to the copper pattern side of a printed circuit board. The inductors to which the present invention is directed are tiny, having a maximum dimension of about 2.5 mm (1/10 inch).

Our U.S. Patent No. 4,588,974 discloses a mounting of contact elements to an inductor core. In that patent, the elements are shallow, U-shaped copper strips whose legs are clamped against the sides of the core to hold the copper to the core until the epoxy adhesive sets. The '974 patent has not provided the best solution to the attachment problem. The attachment has not been completely reliable because the epoxy does not bond well to the copper, the copper having a thin film of copper oxide to which the epoxy does not bond well. Further, from an electrical standpoint, the close proximity of all of that copper to the core and winding adversely affects the Q of the inductor. The problem of attachment arises particularly in the mass producing of tiny inductors wherein the copper contacts having dimensions of about 0.5 mm (0.020 inch) by 1.7 mm (0.070 inch) are to be bonded to the core. Because of the difficulty of adhering epoxy to copper, that surface area simply is too small to make a good, reliable bond. If the contact elements were made with a larger bonding area to make a better attachment, too much copper would be introduced and positioned too close to the winding, with the result that the Q degrades.

Japanese Patent Application No. 58-124213 describes a variable inductance element having a core held between two collars, the space around the core between the collars being filled with a mixture of a thermoplastic resin and magnetic powder. Electrodes connected to the winding are attached to each collar by an insulating layer, the thickness of which is considerably less than that of the electrodes.

An objective of the present invention has been to provide a mounting of a contact element to a miniature inductor that provides a good bond and significantly improves the Q of prior configurations. This objective is attained in accordance with the invention by an inductor having a core, a winding therefor and a mounting for contact elements at each end of the core characterised in that each mounting is adhered by adhesive to the core and in that each mounting is formed from printed circuit board material comprising an epoxy-based board with fibreglass or other fabric spacer which is 175 μm to 760 μm (0.007 to 0.030 inches) thick and a copper strip which is 76 μm (0.003 inches) thick bonded to the spacer.

The inductor uses conventional printed circuit board material as a contact element. The printed circuit board material is a laminate of an impregnated fabric such as fibreglass forming a base and copper with tin plating covering the exposed surface of the copper. The preferred material is thin, being about 250 μm (0.010 inch) in thickness with the base being about 175 μm (0.007 inch) thick and the copper being from (25 μm to 75 μm) (0.001 inch to 0.003 inch) thick. The base could be up to about 760 μm (0.030 inch) thick.

In the forming of sheets of printed circuit board material, it is possible to apply processing techniques by which a very good adherence between the base material and the copper is attained - that is, an adherence that cannot be attained when one is attempting to mass produce tiny little contact strips mounted to tiny core members. Epoxy is relatively easy to adhere to another epoxy-based material such as fibreglass board. Thus, the use of printed circuit board material, which has an epoxy-impregnated base, solves the adherence problem since the tiny contact elements formed of that material can be bonded by the epoxy to the core with relative ease. But there is an additional benefit arising out of the use of the printed circuit board material in that the 175 μm 7 mil thick fibreglass acts as a spacer of the copper away from the winding on the core, thereby improving the Q by a factor of 5-10%.

The invention will now be further described by way of example with reference to the accompanying drawings in which:-

Figure 1 is a perspective view of an inductor in accordance with the present invention; and

Figure 2 is a cross-sectional view taken along lines 2-2 of Figure 1.

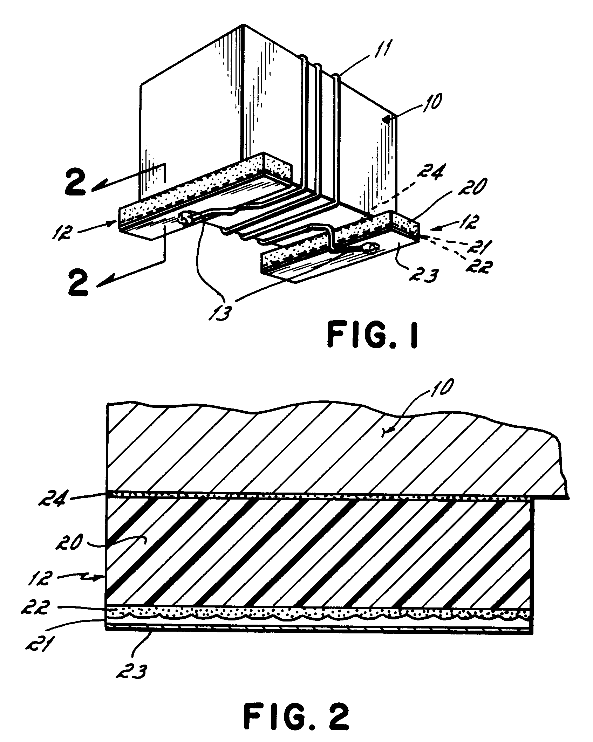

Referring to Figure 1, there is shown a core 10 around which a winding 11 is mounted. Contact elements 12 are secured to the core 10. The winding 11 has ends 13 that are soldered to the contact elements. That inductor is suitable for surface mounting to the copper pattern of a printed circuit board by soldering the contact elements to the copper on the printed circuit board.

The inductor is tiny. It has dimensions which will be set forth below. These dimensions will vary somewhat but are set forth here to provide the order of magnitude of size of inductor to which the present invention is applicable. The core is 2.5 to 6.4 mm (0.100 to 0.250 inch) long, 2.3 to 5.0 mm (0.090 to 0.200 inch) wide, and 1.3 to 3.8 mm (0.050 to 0.150 inch) high. The spacing between the contact elements 12 is about 1.5 mm (0.060 inch). Each contact element is about 0.5 mm (0.020 inch) wide and 1.75 mm (0.070 inch) to 5.0 mm (0.200 inch) long.

As best shown in Figure 2, the contact element 12 is formed from a laminate of an epoxy base fibreglass fabric 20 which is about 175 $\mu$m (0.007 inch) thick and copper 21 that is between 25 $\mu$m and 75 $\mu$m (0.001 inch and 0.003 inch) thick. The copper is bonded to the fibreglass by an adhesive 22 in accordance with the conventional practices in making printed circuit board material. The copper is usually clad with a tin plate indicated at 23.

Each contact element 12 is attached to the core 10 by means of an epoxy 24.

It can be seen from Figure 2 that the 175 $\mu$m (0.007 inch) base material spaces the copper strip 21 a substantial distance away from the core and the winding, thereby improving the Q of the inductor.

## Claims

1. An inductor having a core, a winding therefor and a mounting for contact elements at each end of the core characterised in that each mounting (12) is adhered by adhesive (24) to the core (10) and in that each mounting (12) is formed from printed circuit board material comprising an epoxy-based board with fibreglass or other fabric spacer (20) which is 175 $\mu$m to 760 $\mu$m (0.007 to 0.030 inches) thick and a copper strip (21) which is 76 $\mu$m (0.003 inches) thick bonded to the spacer (20).

2. An inductor as claimed in Claim 1 having a layer (23) of tin plate on the surface of the copper strip (21).

3. An inductor as claimed in Claim 1 or 2 in which the dimension of the core (10) is 2.5 to 6.4 mm (0.100 inch to 0.250 inch) long.

4. An inductor as in Claim 3 in which the contact elements (12) are about 0.5 mm (0.020 inch) wide and are spaced apart by about 1.5 mm (0.060 inch).

## Patentansprüche

1. Induktor mit einem Kern, einer Wicklung dafür und einer Befestigung für Kontaktelemente an jedem Ende des Kerns, **dadurch gekennzeichnet,**
daß jede Befestigung (12) durch einen Klebstoff (24) an dem Kern (10) angeklebt ist, und dadurch, daß jede Befestigung (12) aus Schaltungsplatinenmaterial gebildet ist, das eine Platine auf Epoxy-Grundlage mit einem Abstandshalter (20) aus Fiberglas oder anderem Stoff, der 175 $\mu$m bis 760 $\mu$m (0,007 bis 0,030 Inch) dick ist, sowie einen Kupferstreifen (21), der 76 $\mu$m (0,003 Inch) dick und auf dem Abstandshalter (20) befestigt ist, umfaßt.

2. Induktor gemäß Anspruch 1, mit einer Schicht (23) aus Zinnblech auf der Oberfläche des Kupferstreifens (21).

3. Induktor gemäß Anspruch 1 oder 2, bei dem die Dimension des Kerns (10) 2,5 bis 6,4 mm (0,100 Inch bis 0,250 Inch) lang ist.

4. Induktor gemäß Anspruch 3, bei dem die Kontaktelemente (12) ca. 0,5 mm (0,020 Inch) breit und um ca. 1,5 mm (0,060 Inch) voneinander beabstandet sind.

## Revendications

1. Inducteur comportant un noyau, un enroulement pour ce noyau et une monture pour des éléments de contact à chaque extrémité du noyau, caractérisé en ce que chaque monture (12) est fixée par un adhésif (24) au noyau (10) et en ce que chaque monture (12) est constituée d'un matériau pour plaquette à circuits imprimés comprenant une plaquette à base d'époxy avec une entretoise (20) en fibre de verre ou autre tissu qui présente une épaisseur de 175 $\mu$m à 760 $\mu$m et d'une bande de cuivre (21) qui présente une épaisseur de 76 $\mu$m liée à l'entretoise (20).

2. Inducteur selon la revendication 1, comportant une couche (23) d'une plaque d'étain sur la surface de la bande de cuivre (21).

3. Inducteur selon la revendication 1 ou 2, dans lequel le noyau (10) a comme dimensions une longueur de 2,5 à 6,4 mm.

4. Inducteur selon la revendication 3, dans lequel les éléments de contact (12) ont environ 0,5 mm de large et sont espacés l'un de l'autre d'environ 1,5 mm.

FIG. 1

FIG. 2